# EUROPEAN PATENT SPECIFICATION

(11) **EP 1 786 047 B1**
(45) Date of publication and mention of the grant of the patent: **27.05.2009**
(21) Application number: 06123858.0
(22) Date of filing: 10.11.2006
(51) Int. Cl.: H01L 51/00, H01L 51/44, H01L 31/0224, H01L 31/18

(54) **Solar cell and manufacturing method of the same**
Solarzelle und Herstellungsverfahren dazu
Cellule photovoltaïque et son procédé de fabrication

(30) Priority: 11.11.2005 KR 20050107932
(43) Date of publication of application: 16.05.2007
(73) Proprietor: Samsung SDI Co., Ltd., Suwon-si Gyeonggi-do (KR)
(72) Inventor: Choi, Jae-Man Legal&IP Team,Samsung SDI Co. Ltd.,, Yongin-si, Kyunggi-do (KR); Lee, Ji-Won Legal&IP Team,Samsung SDI Co. Ltd.,, Yongin-si, Kyunggi-do (KR); Lee, Wha-Sup Legal&IP Team,Samsung SDI Co.Ltd., Yongin-si, Kyunggi-do (KR); Ahn, Kwang-Soon Legal&IP Team,Samsung SDI Co. Ltd.,, Yongin-si, Kyunggi-do (KR); Shin, Byong-Cheol Legal&IP Team,Samsung SDI Co. Ltd.,, Yongin-si, Kyunggi-do (KR); Park, Joung-Won Legal&IP Team,Samsung SDI Co. Ltd.,, Yongin-si, Kyunggi-do (KR)
(74) Representative: Hengelhaupt, Jürgen

(56) References cited:
- EP-A- 1 624 494
- WO-A-20/04102677
- US-A- 5 711 824
- HAQUE S A ET AL: "INTERFACE ENGINEERING FOR SOLID-STATE DYE-SENSITIZED NANOCRYSTALLINE SOLAR CELLS: THE USE OF ION-SOLVATING HOLE-TRANSPORTING POLYMERS" ADVANCED FUNCTIONAL MATERIALS, WILEY VCH, WIENHEIM, DE, vol. 14, no. 5, May 2004 (2004-05), pages 435-440, XP001195404 ISSN: 1616-301X

## Description

### BACKGROUND OF THE INVENTION

### 1. Field of the Invention

Aspects of the present invention relate to a solar cell and a manufacturing method thereof, and in particular, to a solar cell with high energy efficiency, and a method of manufacturing the solar cell.

### 2. Description of the Related Art

Generally, a solar cell generates electrical energy using solar energy, an unlimited energy source, in an environmentally friendly way. Typical solar cells include silicon solar cells, dye-sensitized solar cells, etc.

A solar cell typically has a first electrode having a dye-adsorbed porous film formed thereon, and a second electrode facing the first electrode with a predetermined distance therebetween. The dye-sensitized solar cell is produced with simplified processing steps and a lower production cost compared to the silicon solar cell. Furthermore, since the first and second electrodes in the dye-sensitized solar cell are formed with a transparent material, the dye-sensitized solar cell may be used in constructing an outer wall for buildings or greenhouses.

However, the dye-sensitized solar cell has a lower photoelectric conversion efficiency than the silicon solar cell, and it is limited in the practical usage thereof. In order to increase the photoelectric conversion efficiency, it has been proposed that the reflectivity of the second electrode should be increased or that light-scattering particles should be used, but the proposed methods are limited in the extent to which they can increase the photoelectric conversion efficiency of the dye-sensitized solar cell. In this regard, it is desirable to develop a new technology for enhancing the photoelectric conversion efficiency of the dye-sensitized solar cell as well as of other kinds of solar cells. Document by S.A. Hague et al, Adv. Fruct. Mat. 2004, 14, 435-440 describes a dye-sensitized solar cell. Document US 5,711,824 and EP-A-1 624 494 disclose inorganic solar cells with structured electrodes.

### SUMMARY OF THE INVENTION

Aspects of the present invention provide a solar cell with enhanced photoelectric conversion efficiency, and a method of manufacturing the solar cell.

According to a first aspect of the invention there is provided a solar cell as recited in claim 1. Further advantageous embodiments are recited in claim 2-7, preferably in the range of 50 nm to 1500 nm, most preferred in the range of 150 nm to 400 nm.

According to a second aspect of the invention there is provided a method of manufacturing a solar cell as recited in claim 8.

Further advantageous embodiments are recited in claims 9-15.

The root mean square roughness of the substrate may be controlled through mechanical or chemical treatment. The mechanical or chemical treatment may include any of sandblasting, scratching, or plasma etching. The chemical treatment may include etching performed with a solution selected from the group consisting of nitric acid, hydrochloric acid, hydrofluoric acid, and mixtures thereof.

### BRIEF DESCRIPTION OF THE DRAWINGS

These and/or other aspects and advantages of the invention will become apparent and more readily appreciated from the following description of the embodiments, taken in conjunction with the accompanying drawings of which:
FIG. 1 is a sectional view of a solar cell according to an embodiment of the present invention;
FIG. 2 is an atomic force microscope (AFM) image of a surface of a first electrode for a solar cell according to the embodiment of FIG. 1, wherein the electrode has prominent and depressed portions according to ; and
FIG. 3 is a sectional view of a solar cell according to another embodiment of the present invention.

### DETAILED DESCRIPTION OF THE EMBODIMENTS

Reference will now be made in detail to the present embodiments of the present invention, examples of which are illustrated in the accompanying drawings, wherein like reference numerals refer to the like elements throughout. The embodiments are described below in order to explain the present invention by referring to the figures.

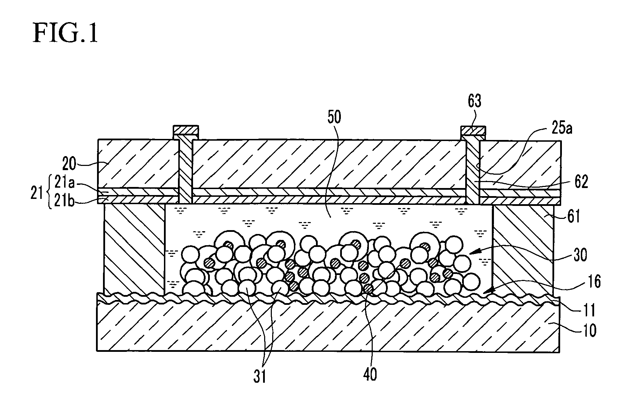

FIG. 1 is a sectional view of a solar cell according to an embodiment of the present invention.

As shown in FIG. 1, the solar cell according to aspects of the present embodiment includes a first substrate 10 with a first electrode 11 and a porous film 30 including an adsorbed dye 40, a second substrate 20 facing the first substrate 10 with a predetermined distance therebetween and having a second electrode 21, and an electrolyte 50 disposed between the first and second substrates 10 and 20. The dye-adsorbed porous film 30 has a role of generating electrons upon receipt of the light incident thereto and delivering the electrons to the first electrode 11. The porous film 30 and the adsorbed dye 40 may be collectively referred to as a light absorption layer. The first substrate 10 having the first electrode 11 and the light absorption layer may be collectively referred to as the substrate/electrode/light absorption layer assembly. A separate case (not shown) may be provided external to the first and second substrates 10 and 20.

In this embodiment, the first substrate 10, which functions as a support for the first electrode 11, is formed with a transparent material that allows light to pass therethrough. The first substrate 10 may be formed with glass or plastic. The plastic may be selected from polyethylene terephthalate (PET), polyethylene naphthalate (PEN), polycarbonate (PC), polypropylene (PP), polyimide (PI), and triacetyl cellulose (TAC). The first substrate 10 is not limited to these materials, and other materials are possible.

The first electrode 11 provided on the first substrate 10 may be formed with indium tin oxide (ITO), fluorine tin oxide (FTO), antimony tin oxide (ATO), zinc oxide (ZO), tin oxide (TO), ZnO-Ga₂O₃, or ZnO-Al₂O₃. The first electrode 11 is not limited to these materials, and other materials are possible. The first electrode 11 may be formed with a transparent material-based single layer structure, or a laminated layer structure.

In this embodiment, a contact area region 16 is formed between the first electrode 11 and the porous film 30. The contact area region 16 is for example made by forming prominent and depressed portions at the first electrode 11. More specifically, prominent and depressed portions are formed at a surface of the first substrate 10, and the first electrode 11 is formed on that rugged surface of the first substrate 10. The first electrode 11 conforms to the surface of the first substrate 10 such that the surface of the first electrode 11 also has the prominent and depressed portions, i. e. has a specific surface texture.

Surface texture is the combination of fairly short wavelength deviations of a surface from the nominal surface. Texture includes roughness, waviness, and lay, that is, all of the deviations that are shorter in wavelength than form error deviations.

Roughness includes the finest (shortest wavelength) irregularities of a surface. Roughness generally results from a particular production process or material condition. Waviness includes the more widely spaced (longer wavelength) deviations of a surface from its nominal shape.

Waviness refers to the irregularities which are outside the roughness width cut off values and may be the result of workpiece or tool deflection during machining, vibrations or tool runout.

Lay refers to the predominant direction of the surface texture. Ordinarily lay is determined by the particular production method and geometry used. Turning, milling, drilling, grinding, and other cutting tool machining processes usually produce a surface that has lay: striations or peaks and valleys in the direction that the tool was drawn across the surface. The shape of the lay can take one of several forms as shown below. Other processes produce surfaces with no characteristic direction: sand casting, peening, and grit blasting. Sometimes these surfaces are said to have a nondirectional, particulate, or protuberant lay.

The root mean square (Rms) of the surface roughness of the surface of the first substrate 10 is in the range of 10nm to 3000nm, preferably in the range of 50 to 1500nm, most preferred in the range of 150 to 400nm. Since the first electrode 11 conforms to the surface of the first substrate 10, the Rms of the surface roughness at the surface of the first electrode 11 with the porous film 30 may also be in the range of 10nm to 3000nm. Typically, but not necessarily, the surface roughness of the first substrate 10 may be determined before the first electrode is deposited thereon, or in the absence of the first electrode and the surface roughness of the first electrode may be measured before the light absorption layer is formed thereon, or in the absence of the light absorption layer. The methods of determining the roughness of the surfaces are common knowledge and inter alia include optical and mechanical procedures. However, the surface roughness may also be determined under other methods or conditions.

It is difficult in practice to form prominent and depressed portions to provide an Rms of the surface roughness of less than 10nm. On the other hand, when the Rms of the surface roughness exceeds 3000nm, light transmittance is lowered and the energy efficiency deteriorates to such an extent as to offset the efficiency enhancement gained by the increase in the contact area. Furthermore, if the Rms of the surface roughness does not exceed 3000nm, the electron transfer may be performed more effectively. In addition, it has been shown that a Rms of the surface roughness of the electrode 11 in the range of 50 to 1500nm results in an outstanding range of short circuit current of the solar cell and a Rms of the surface roughness of the electrode 11 in the range of 150 to 400nm in addition leads to a solar cell having an extraordinary efficiency (see especially experimental part, table 1).

Increasing the Rms of the surface roughness of the electrode 11 enlarges the contact area between the first electrode 11 and the porous film 30. The lay of the surface texture may be formed in the shape of steps, meshes, scratches, scars, beds or other shapes.

The porous film 30 is placed or formed on the first electrode 11. The porous film 30 includes metallic oxide particles 31 having a nanometer-level mean particle diameter. The metallic oxide particles 31 may comprise titanium oxide, zinc oxide, tin oxide, strontium oxide, indium oxide, iridium oxide, lanthanum oxide, vanadium oxide, molybdenum oxide, tungsten oxide, niobium oxide, magnesium oxide, aluminium oxide, yttrium oxide, scandium oxide, samarium oxide, gallium oxide, or strontium titanium oxide. For instance, the metallic oxide particles 31 of the porous film 30 may comprise titanium oxide TiO₂. The metallic oxide particles 31 are not limited to these materials, and other materials are possible.

As a non-limiting example, the metallic oxide particles 31 with a nanometer-level mean particle diameter may be uniformly distributed with suitable porosity and surface roughness to form the porous film 30.

In order to enhance the performance characteristics of the porous film 30, a polymer (not shown), conductive micro particles (not shown), and light-scattering particles (not shown) may be added to the porous film 30.

The polymer may be added to the porous film 30 to increase the porosity, diffusivity, and viscosity of the porous film 30, thereby enhancing the film formation and adhesion thereof. The polymer may be selected from polyethylene glycol (PEG), polyethylene oxide (PEO), polyvinyl alcohol (PVA), and polyvinyl pyrrolidone (PVP). The polymer is not limited to these materials, and other materials are possible. The molecular weight of the polymer may be selected taking into account the method and conditions of formation of the porous film 30.

Conductive micro particles may be added to the porous film 30 to enhance the mobility of the excited electrons. For instance, the conductive micro particles may comprise indium tin oxide. The conductive micro particles are not limited to these materials, and other materials are possible.

Light-scattering particles may be added to the porous film 30 to extend the optical path within the solar cell to enhance the photoelectric conversion efficiency thereof. The light-scattering particles may be formed with the same material as the metallic oxide particles 31 for the porous film 30. The light scattering particles are not limited to these materials, and other materials are possible. The light-scattering particles preferably have a mean particle diameter of 100nm or more to effectively scatter the light.

The dye 40 is adsorbed onto the surface of the metallic oxide particles 31 of the porous film 30 to absorb external light and excite electrons. The dye 40 may be formed with a metal complex containing aluminium (AI), platinum (Pt), palladium (Pd), europium (Eu), lead (Pb), or iridium (Ir), or with a ruthenium (Ru) complex. Ruthenium belongs to the platinum group, and a ruthenium-containing dye is commonly used as an organic metal complex compound. The metal complex is not limited to these materials, and other materials are possible.

Furthermore, a dye may be selected that is capable of improving the absorption of long wavelength visible rays to enhance the photoelectric conversion efficiency and/or that is capable of easily emitting electrons. For example, an organic dye may be used. The organic dye may be used independently or in association with a metal complex such as, for example, the ruthenium complex mentioned above. The organic dye may be selected from coumarin, porphyrin, xanthene, riboflavin, and triphenylmethane. The organic dye is not limited to these materials, and other materials are possible.

The second substrate 20, which faces the first substrate 10 in the assembled solar cell, supports the second electrode 21, and is formed with a transparent material. The second substrate 20 may be formed with glass or plastic. The plastic may be selected from polyethylene terephthalate, polyethylene naphthalate, polycarbonate, polypropylene, polyimide, and triacetyl cellulose. The second substrate 21 is not limited to these materials, and other materials are possible.

The second electrode 21 formed on the second substrate 20 faces the first electrode 11 and includes a transparent electrode 21a and a catalyst electrode 21b.

The transparent electrode 21a may be formed with a transparent material such as indium tin oxide, fluorine tin oxide, antimony tin oxide, zinc oxide, tin oxide, ZnO-Ga₂O₃, and ZnO-Al₂O₃. The transparent electrode 21a is not limited to these materials, and other materials are possible. The transparent electrode 21a may be formed with a single layer structure based on a transparent material, or with a laminated layer structure. The catalyst electrode 21b activates the redox couple, and may be formed with platinum, ruthenium, palladium, iridium, rhodium, osmium, carbon, WO₃, or TiO₂. The catalyst electrode 21b is not limited to these materials, and other materials are possible.

In this embodiment, the prominent and depressed portions functioning as the contact area region are not formed at the second electrode 21, and hence the Rms surface roughness of the first electrode 11 is greater than the Rms surface roughness of the second electrode 21. The Rms of the surface roughness of the second electrode 21 may be less than 10nm.

The first and second substrates 10 and 20 are attached to each other using an adhesive 61. An electrolyte 50 is injected into the interior between the first and second electrodes 11 and 21 through holes 25a formed at the second substrate 20 and the second electrode 21. The electrolyte 50 is uniformly diffused into the porous film 30. The electrolyte 50 may comprise a solution including iodide and triiodide. The electrolyte receives and transfers electrons from the second electrode 21 to the dye 40 through reduction and oxidation. The holes 25a formed at the second substrate 20 and the second electrode 21 are sealed by an adhesive 62 and a cover glass 63.

The electrolyte 30 is not limited to a liquid electrolyte as described herein. For example, the electrolyte 30 may be in other forms, such as a gel or solid electrolyte, provided that the electrolyte is present between the first and second electrodes 11 and 21.

When external light such as sunlight hits the interior of the solar cell, photons are absorbed into the dye so that the dye is shifted from an inactive state to an excited state to thereby generate electron-hole pairs. The excited electrons migrate into the conduction bands of the metallic oxide particles 31 for the porous film 30, and flow to an external circuit (not shown) through the first electrode 11, and are then transferred to the second electrode 21. Meanwhile, as the iodide within the electrolyte 50 is oxidized into triiodide, the oxidized dye is reduced, and the triiodide is reacts with the electrons that have reached the second electrode 21 to be thereby reduced into iodide. The solar cell operates due to the migration of electrons.

Unlike the silicon solar cell, the dye-sensitized solar cell operates through a reaction at an interface, in particular, the interface between the porous film 30 of the light absorption layer and the electrode 11. Hence, it is beneficial to improve the characteristics of this interface. In this embodiment, a contact area enlargement region 16 is formed at the first substrate 10 and the first electrode 11 with prominent and depressed portions to thereby improve the contact characteristic thereof. The contact characteristic of the first electrode 11 and the porous film 30 is improved and the contact area therebetween is increased, thereby enhancing the mobility and speed of the electrons.

In this embodiment, the contact area enlargement region 16 is formed by creating prominent and depressed portions at the first substrate 10. The first electrode 11, formed on the first substrate 10 conforms to the first substrate so that the contact area enlargement region 16 is formed at the first electrode 11. In other words, the surface of the first electrode 11 has the same prominent and depressed portions that were on the surface of the first substrate. When the prominent and depressed portions are formed at the first substrate 10, processing is easily carried out, and the first electrode 11 is protected from possible processing failure, compared to the case in which the prominent and depressed portions are formed only at the first electrode 11 and not at the first substrate 10. When the prominent and depressed portions are directly formed at the first electrode 11 through etching, the first electrode 11 may suffer unwanted damage.

A method of manufacturing the above-structured solar cell will be now explained in detail.

A first substrate 10 made of a transparent material such as glass or plastic is provided. The plastic may be selected from polyethylene terephthalate, polyethylene naphthalate, polycarbonate, polypropylene, polyimide, and triacetyl cellulose. As noted above, the first substrate 10 is not limited to these materials, and other materials are possible.

Thereafter, prominent and depressed portions are formed at the first substrate 10 through mechanical treatment or chemical etching. The formation of for example prominent and depressed portions is not limited to these methods and other methods are possible. The mechanical treatment may be carried out by sandblasting or scratching, and the chemical etching may be performed by plasma etching or by dipping the substrate in hydrofluoric acid, nitric acid, hydrochloric acid, or mixed solutions thereof. Consequently, the Rms of the surface roughness of the first substrate 10 comes to be in the range of 10nm to 3000nm. The prominent and depressed portions defining the surface texture may be in the shape of steps, meshes, scratches, scars, beds or other shapes.

A conductive layer is deposited onto a surface of the first substrate 10 with the prominent and depressed portions through sputtering, chemical vapor deposition (CVD), or spray pyrolysis deposition (SPD) to thereby form the first electrode 11. The formation of the first electrode 11 is not limited to these methods and other methods are possible. Because the first electrode 11 is relatively thin, the prominent and depressed portions that were formed at the first substrate 10 also appear at the surface of the first electrode 11. The resulting prominent and depressed portions of the first electrode 11 function as the contact area enlargement region 16. With the formation of the surface texture of the substrate 10 (especially the prominent and depressed portions), the Rms of the surface roughness of the first electrode 11 comes to be in the range of 10nm to 3000nm. As stated above, the first electrode 11 may be formed with indium tin oxide, fluorine tin oxide, antimony tin oxide, zinc oxide, tin oxide, ZnO-Ga₂O₃, or ZnO-Al₂O₃ or other conductive materials. The first electrode 11 may be formed with a single layer structure based on a transparent material, or with a laminated layer structure.

A paste containing metallic oxide particles 31 is coated onto the first electrode 11 and heat-treated to thereby form a porous film 30. The paste may contain a polymer, light-scattering particles, and conductive micro particles in addition to the metallic oxide.

The coating of the paste may be performed in various ways including with a doctor blade, by screen printing, by spin coating, by spraying, and by wet coating. The method of coating may be selected to be compatible with a particular paste that is used. Alternatively, if a particular method of coating has already been selected, the paste may be selected to be compatible with the chosen method of coating.

If the paste contains a binder, the heat treatment o may be performed on the paste-coated electrode at 450 to 600°C for 30 minutes. On the other hand, if the paste does not contain a binder, the heat treatment may be performed at 200°C or less. However, different heating temperatures may be selected depending upon the composition of the paste, and heating temperature of the paste-coated electrode is not limited to the above examples.

Thereafter, the first substrate 10 with the first electrode 11 and the porous film 30 formed thereon is dipped in a alcoholic solution containing a dissolved dye for a predetermined period of time, thereby adsorbing the dye 40 into the porous film 30, thereby creating the light absorption layer.

The transparent electrode 21a and a catalyst electrode 21b are sequentially formed on the second substrate 20, which can be made of glass or plastic, for example, to thereby form a second electrode 21. The material for the second substrate 20 may be the same as that for the first substrate 10, and hence a detailed explanation thereof will be omitted. Similarly, the material for the transparent electrode 21a may be the same as that for the first electrode 11, and a detailed explanation thereof will be omitted.

The catalyst electrode 21b may be formed, for example, with platinum, ruthenium, rhodium, palladium, iridium, osmium, WO₃, TiO₂, or C. The formation of the catalyst electrode 21b may be accomplished, for example, through physical vapour deposition (such as electroplating, sputtering, and electron beam deposition), or wet coating (such as spin coating, dip coating, and flow coating). For example, when the catalyst electrode 21b is formed with platinum, H₂PtCl₆ may be dissolved in an organic solvent such as methanol, ethanol, and isopropyl alcohol (IPA) to make a solution, and the solution may be wet-coated onto the transparent electrode 21a and heat-treated at 400°C under an air or oxygen atmosphere.

Thereafter, the first and second substrates 10 and 20 are arranged such that the first electrode 11 and the porous film 30 face the second electrode 21, and are attached to each other using an adhesive 61. The adhesive 61 may be formed with a thermoplastic polymer film (such as, for example, a resin provided by DuPont under the registered trademark SURLYN™), an epoxy resin, or an ultraviolet hardener. When the adhesive 61 is formed with a thermoplastic polymer film, the thermoplastic polymer film is placed between the first and second substrates 10 and 20, which are then thermally pressed, thereby attaching the first and second substrates 10 and 20 to each other.

An electrolyte 50 is injected into the interior between the first and second substrates 10 and 20 through holes 25a formed at the second substrate 20 and the second electrode 21, and the holes 25a are sealed using an adhesive 62 and a cover glass 63. (if a solid or other non-liquid form of electrolyte is used, the electrolyte is added before the first and second substrates 10 and 20 are joined.) In this way, a solar cell is completed. A separate case (not shown) may be provided external to the first and second substrates 10 and 20.

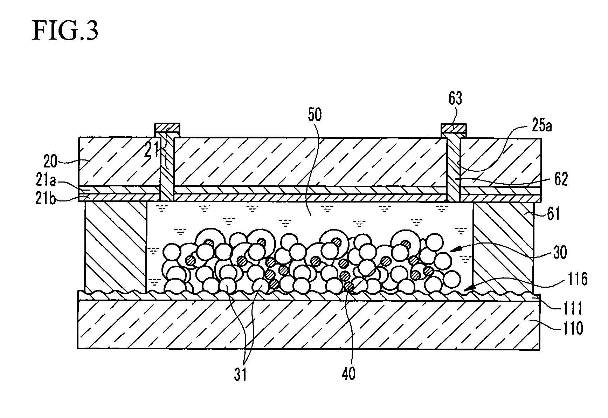

FIG. 3 is a sectional view of a solar cell according to another embodiment of the present invention. In this embodiment, like reference numerals are used for the same or similar structural components as those related to the previous embodiment, and only the different structures will now be explained. A method of manufacturing the solar cell is also substantially the same as that related to the previous embodiment, and hence a detailed explanation thereof will be omitted except for the formation of the first electrode.

In this embodiment, the first substrate 110 has a flat and smooth surface with no rugged portion. Prominent and depressed portions are formed at the first electrode 111 to create a contact area region 116. The first electrode 111 is formed through sputtering, chemical vapour deposition, or spray pyrolysis deposition, and the processing conditions are controlled such that the surface roughness of the first electrode 111 has an Rms of 10nm to 3000nm.

A solar cell according to the present invention will be now specifically explained by way of examples. The examples are given only to illustrate the present invention, but not intended to limit the scope of the present invention.

### Example 1

A first substrate was formed with soda-lime glass having a horizontal side of 2.2cm, a vertical side of 2.2cm, and a thickness of 1.1 mm. The first substrate was ultrasonically cleaned using distilled water. The clean first substrate was dipped in a hydrofluoric aqueous solution containing 49 wt% of hydrofluoric acid for 20 minutes, and etched. The first substrate was then ultrasonic-wave cleaned using distilled water, and an indium tin oxide layer with a thickness of 500nm was deposited onto the first substrate through spray pyrolysis deposition, thereby forming a first electrode.

A paste containing TiO₂ particles with a mean particle diameter of 7nm-50nm was coated onto a surface of the first electrode with an area of 1cm² through screen printing, and heat-treated at 450°C for 30 minutes to thereby form a TiO₂-contained porous film with a thickness of 15µm.

The first substrate with the porous film and the first electrode was dipped in a 0.3mM solution of ruthenium (4,4-dicarboxy-2,2'-bipyridine)₂(NCS)₂ for 24 hours, thereby adsorbing the dye into the porous film. The dye-adsorbed porous film was cleaned using ethanol.

A second substrate was formed with soda-lime glass having a horizontal side of 2.2cm, a vertical side of 2.2cm, and a thickness of 1.1 mm. The second substrate was ultrasonically cleaned using distilled water. Two holes were formed at the second substrate. Thereafter, an indium tin oxide layer with a thickness of 500nm was deposited onto the second substrate through spray pyrolysis deposition to form a transparent electrode. A catalyst electrode based on platinum with a surface resistivity of 3 Ω/sq was formed on the transparent electrode through sputtering.

The first and second substrates were arranged such that the porous film formed on the first electrode faced the second electrode. A thermoplastic polymer film was disposed between the first and second substrates, and thermally pressed to thereby attach the first and second substrates to each other. An electrolyte was injected into the interior between the first and second substrates through the two holes formed at the second substrate and the second electrode, and the holes were sealed using a thermoplastic polymer film and a cover glass, thereby completing a solar cell. The electrolyte was based on a solution wherein 21.928g of tetrapropylammonium iodide and 1.931g of iodine (I₂) were dissolved in 100ml of a mixed solvent of 80 vol% of ethylene carbonate and 20 vol% of acetonitrile.

### Example 2

A solar cell was manufactured in the same way as in Example 1 except that the first substrate was etched for 40 minutes.

### Example 3

A solar cell was manufactured in the same way as in Example 1 except that the first substrate was etched for 90 minutes.

### Example 4

A solar cell was manufactured in the same way as in Example 1 except that the first substrate was etched for 150 minutes.

### Example 5

A solar cell was manufactured in the same way as in Example 1 except that the first substrate was etched for 300 minutes.

### Example 6

A solar cell was manufactured in the same way as in Example 1 except that the first substrate was etched for 600 minutes.

### Comparative Example 1

A solar cell was manufactured in the same way as in Example 1 except that the first substrate was not etched.

### Comparative Example 2

A solar cell was manufactured in the same way as in Example 1 except that the first substrate was etched for 1200 minutes.

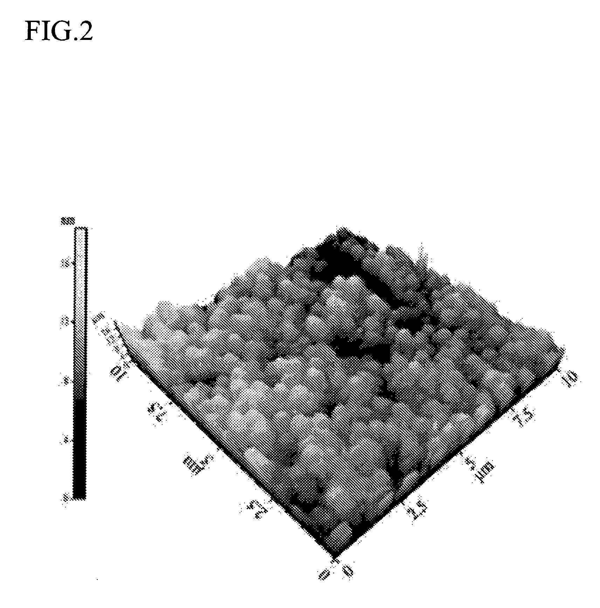

With the solar cell according to the Example 2, an exemplary atomic force microscope (AFM) image of the surface of the first electrode is presented in FIG. 2. It can be predicted that the contact area between the first electrode and the porous film would be increased due to the surface texture having prominent and depressed portions. Only an image of the surface of the first electrode of the solar cell according to Example 2 is shown in FIG. 2, but the same type of result may be expected with the other examples.

For the solar cells according to Examples 1 to 6 and Comparative Examples 1 and 2, the Rms of the surface roughness, open circuit voltage, short circuit current, fill factor, light transmittance, and efficiency are listed in Table 1. The open circuit voltage was evaluated from the voltage-current curve where a light source of 100mW/cm² was corrected by a Si standard cell, and measured. For clearer understanding, the listing sequence is made in accordance with the dimensions of the Rms of the surface roughness.

**Table 1**

| | Rms of surface roughness (nm) | Open circuit voltage (V) | Short circuit current (mA) | Fill factor | Light transmittance (%) | Efficiency (%) |
|---|---|---|---|---|---|---|
| Com. Ex. 1 | 8 | 0.763 | 6.810 | 0.613 | 82.2 | 3.187 |
| Ex.1 | 38 | 0.751 | 7.090 | 0.611 | 82.1 | 3.253 |
| Ex.2 | 70 | 0.713 | 8.185 | 0.600 | 81.4 | 3.499 |
| Ex.3 | 180 | 0.724 | 8.214 | 0.595 | 81.3 | 3.538 |
| Ex.4 | 325 | 0.691 | 8.199 | 0.641 | 80.5 | 3.632 |
| Ex.5 | 680 | 0.678 | 8.105 | 0.613 | 80.1 | 3.370 |
| Ex.6 | 1280 | 0.671 | 8.091 | 0.591 | 79.1 | 3.209 |
| Com. Ex.2 | 3200 | 0.614 | 7.610 | 0.577 | 76.5 | 2.700 |

It is known from Table 1 that the solar cells according to Examples 1 to 6 have very high short circuit currents with fill factors similar to each other, compared to the solar cells according to Comparative Examples 1 and 2. The short circuit currents of the solar cells according to Examples 1 to 6, especially according to Examples 2 to 6, were higher than those of the solar cells according to Comparative Examples 1 and 2, and this was presumed to be due to the increase in contact area between the porous film and the first electrode. It turned out that the solar cells according to Examples 1 to 6, especially according to Examples 3 and 4, had excellent efficiency due to the high short circuit current thereof, compared to the solar cells according to Comparative Examples 1 and 2. Hence, it is shown that the Rms of the surface roughness should be in the range of 10 to 3000nm, preferably in the range of 50 to 1500 nm (with respect to the short circuit current of Examples 2 to 6), most preferred in the range of 150 to 400nm (with respect to the efficiency of Examples 3 and 4).

As the Rms of the surface roughness increased, the light transmittance deteriorated. At an Rms of the surface roughness of 3200, according to the solar cell of Comparative Example 2, the decrease in efficiency due to the deterioration in light transmittance was greater than the increase in efficiency due to the enhancement in short circuit current based upon the increased contact area, and hence, the overall efficiency was lower.

As described above, with the solar cell according to aspects of the present invention, a contact area enlargement region is formed at the first electrode at the interface with the light absorption layer, thereby increasing and enhancing the contact characteristics of the light absorption layer and the first electrode and increasing the contact area therebetween. Accordingly, the mobility and migration speed of the excited electrons are improved so that the short circuit current intensity is increased, and the photoelectric conversion efficiency of the solar cell is enhanced.

It is explained in relation to the embodiments described herein that prominent and depressed portions are formed as a contact area enhancement region, but the present invention is not limited thereto. That is, various structural components may be provided to increase the contact area between the first electrode and the porous film.

It is explained above that a dye-sensitized solar cell is exemplified as a solar cell. However, the inventive structure may be applied to other types of solar cells. That is, other types of solar cells having an electrode and a light absorption layer may have an increased contact area between the electrode and the light absorption layer.

## Claims

1. A solar cell comprising:
a substrate (10);
an electrode (11) formed on the substrate (10); and
a light absorption layer formed on the electrode (11) and comprising a porous film (30) which includes metallic oxide particles (31) having a nanometer-level mean particle diameter and a dye (40) adsorbed onto the surface of the metallic oxide particles (31),
**characterized in that** a contact enlargement region (16) is formed between the electrode (11) and the light absorption layer, wherein a root mean square surface roughness of the electrode (11) in the contact enlargement region (16) is in the range of 10 nm to 3000 nm.

2. The solar cell of claim 1, wherein the root mean square of the surface roughness of the electrode (11) is in the range of 50 nm to 1500 nm.

3. The solar cell of claim 2, wherein the root mean square of the surface roughness of the electrode (11) is in the range of 150 nm to 400 nm.

4. The solar cell of any of the preceding claims, wherein a lay of the contact enlargement region (16) includes the shapes of steps, meshes, scratches, scars or beds.

5. The solar cell of any of the preceding claims, wherein a root mean square surface roughness of the substrate (10) is in the range of 10 nm to 3000 nm.

6. The solar cell of claim 5, further comprising:
a second substrate (20), the first and second substrates (10, 20) facing each other; and
a second electrode (21) formed on the second substrate (20),
wherein the root mean square surface roughness of the first electrode (11) is greater than a root mean square surface roughness of the second electrode (21).

7. The solar cell of any of the preceding claims, wherein the solar cell is a dye-sensitized solar cell.

8. A method of manufacturing a solar cell comprising the steps of:
providing a substrate (10); '
forming an electrode (11) on a surface of the substrate (10) and controlling processing conditions of the forming such that a contact enlargement region (16), which is designated for bearing a light absorption layer, is formed on the electrode (11), wherein the processing conditions are selected such that a root mean square of roughness of a surface of the contact enlargement region (16) of the electrode (11) is in the range of 10 nm to 3000 nm; and
forming the light absorption layer on the electrode (11), the light absorption layer comprising a porous film (30) which includes metallic oxide particles (31) having a nanometer-level mean particle diameter and a dye (40) adsorbed onto the surface of the metallic oxide particles (31).

9. The method of claim 8, wherein the processing conditions in the step of forming of the electrode (11) are selected such that the root mean square of roughness of a surface of the contact enlargement region (16) of the electrode (11) is in the range of 50 nm to 1500 nm.

10. The method of claim 9, wherein the processing conditions in the step of forming of the electrode (11) are selected such that the root mean square of roughness of a surface of the contact enlargement region (16) of the electrode (11) is in the range of 150 nm to 400 nm

11. The method of one of claims 8 to 10, wherein the step of providing a substrate (10) includes the controlling of processing conditions of a forming of the substrate (10) such that a root mean square of roughness of a surface of the substrate (10) is in the range of 10 nm to 3000 nm in a region which is designated for bearing the electrode (11).

12. The method of claim 11, wherein the root mean square roughness of the substrate (10) is controlled through mechanical or chemical treatment.

13. The method of claim 12, wherein the mechanical or chemical treatment includes any of sandblasting, scratching, or plasma etching.

14. The method of claim 12, wherein the chemical treatment includes etching performed with a solution selected from the group consisting of nitric acid, hydrochloric acid, hydrofluoric acid, and mixtures thereof.

15. The method of one of claims 8 to 14, wherein the solar cell is a dye-sensitized solar cell and wherein the step of forming the light absorption layer on the electrode (11) comprises:
coating a paste containing metallic oxide particles (31) having a nanometer-level mean particle diameter onto the electrode (11) and heat-treating the same to form a porous film (30); and
dipping the electrode (11) with the porous film (30) in a solution containing a dye (40) and thereby absorbing the dye (40) into the porous film (30).

## Patentansprüche

1. Eine Solarzelle, umfassend:
ein Substrat (10);
eine auf dem Substrat (10) ausgebildete Elektrode (11); und
eine auf der Elektrode (11) ausgebildete Lichtabsorptionsschicht, die einen porösen Film (30) umfasst, der Metalloxidpartikel (31) mit mittlerem Partikeldurchmesser im Nanometerbereich sowie einen auf die Oberfläche der Metalloxidpartikel (31) adsorbierten Farbstoff (40) beinhaltet,
**dadurch gekennzeichnet, dass** ein Kontaktvergrößerungsbereich (16) zwischen der Elektrode (11) und der Lichtabsorptionsschicht ausgebildet ist, wobei ein quadratischer Mittelwert der Oberflächenrauigkeit der Elektrode (11) in dem Kontaktvergrößerungsbereich (16) in der Spanne zwischen 10 nm und 3000 nm liegt.

2. Die Solarzelle nach Anspruch 1, wobei der quadratische Mittelwert der Oberflächenrauigkeit der Elektrode (11) in der Spanne zwischen 50 nm und 1500 nm liegt.

3. Die Solarzelle nach Anspruch 2, wobei der quadratische Mittelwert der Oberflächenrauigkeit der Elektrode (11) in der Spanne zwischen 150 nm und 400 nm liegt.

4. Die Solarzelle nach irgendeinem der vorhergehenden Ansprüche, wobei eine Beschaffenheit des Kontaktvergrößerungsbereichs (16) die Formen Stufen, Gitter, Kratzer, Narben oder Betten beinhaltet.

5. Die Solarzelle nach irgendeinem der vorhergehenden Ansprüche, wobei ein quadratischer Mittelwert der Oberflächenrauigkeit des Substrats (10) in der Spanne zwischen 10 nm und 3000 nm liegt.

6. Die Solarzelle nach Anspruch 5, ferner umfassend:
ein zweites Substrat (20), wobei die ersten und zweiten Substrate (10, 20) einander gegenüberliegen; und
eine auf dem zweiten Substrat (20) ausgebildete zweite Elektrode (21),
wobei der quadratische Mittelwert der Oberflächenrauigkeit der ersten Elektrode (11) größer ist als ein quadratischer Mittelwert der Oberflächenrauigkeit der zweiten Elektrode (21).

7. Die Solarzelle nach irgendeinem der vorhergehenden Ansprüche, wobei die Solarzelle eine Farbstoffsolarzelle ist.

8. Ein Verfahren zur Herstellung einer Solarzelle, das folgende Schritte umfasst:
Bereitstellen eines Substrats (10);
Ausbilden einer Elektrode (11) auf einer Oberfläche des Substrats (10) und Steuern von Verarbeitungsbedingungen des Ausbildens derart, dass ein Kontaktvergrößerungsbereich (16), der zum Tragen einer Lichtabsorptionsschicht bestimmt ist, auf der Elektrode (11) ausgebildet wird, wobei die Verarbeitungsbedingungen derart gewählt werden, dass ein quadratischer Mittelwert der Rauigkeit einer Oberfläche des Kontaktvergrößerungsbereichs (16) der Elektrode (11) in der Spanne zwischen 10 nm und 3000 nm liegt; und
Ausbilden der Lichtabsorptionsschicht auf der Elektrode (11), wobei die Lichtabsorptionsschicht einen porösen Film (30) umfasst, der Metalloxidpartikel (31) mit mittlerem Partikeldurchmesser im Nanometerbereich sowie einen auf die Oberfläche der Metalloxidpartikel (31) adsorbierten Farbstoff (40) beinhaltet.

9. Das Verfahren nach Anspruch 8, wobei die Verarbeitungsbedingungen in dem Schritt des Ausbildens der Elektrode (11) derart gewählt werden, dass der quadratische Mittelwert der Rauigkeit einer Oberfläche des Kontaktvergrößerungsbereichs (16) der Elektrode (11) in der Spanne zwischen 50 nm und 1500 nm liegt.

10. Das Verfahren nach Anspruch 9, wobei die Verarbeitungsbedingungen in dem Schritt des Ausbildens der Elektrode (11) derart gewählt werden, dass der quadratische Mittelwert der Rauigkeit einer Oberfläche des Kontaktvergrößerungsbereichs (16) der Elektrode (11) in der Spanne zwischen 150 nm und 400 nm liegt.

11. Das Verfahren nach einem der Ansprüche 8 bis 10, wobei der Schritt des Bereitstellens eines Substrats (10) beinhaltet, die Verarbeitungsbedingungen eines Ausbildens des Substrats (10) derart zu steuern, dass ein quadratischer Mittelwert der Rauigkeit einer Oberfläche des Substrats (10) in einem Bereich, der zum Tragen der Elektrode (11) bestimmt ist, in der Spanne zwischen 10 nm und 3000 nm liegt.

12. Das Verfahren nach Anspruch 11, wobei der quadratische Mittelwert der Rauigkeit des Substrats (10) durch mechanische oder chemische Behandlung gesteuert wird.

13. Das Verfahren nach Anspruch 12, wobei die mechanische oder chemische Behandlung irgendeines von Sandstrahlen, Verkratzen oder Plasmaätzen beinhaltet.

14. Das Verfahren nach Anspruch 12, wobei die chemische Behandlung Ätzen beinhaltet, das mit einer aus der aus Salpetersäure, Salzsäure, Fluorwasserstoffsäure und Mischungen derselben bestehenden Gruppe ausgewählten Lösung durchgeführt wird.

15. Das Verfahren nach einem der Ansprüche 8 bis 14, wobei die Solarzelle eine Farbstoffsolarzelle ist und wobei der Schritt des Ausbildens der Lichtabsorptionsschicht auf der Elektrode (11) Folgendes umfasst:
Auftragen einer Paste, die Metalloxidpartikel (31) mit mittlerem Partikeldurchmesser im Nanometerbereich beinhaltet, auf die Elektrode (11) und Wärmebehandeln derselben, um einen porösen Film (30) auszubilden; und
Eintauchen der Elektrode (11) mit dem porösen Film (30) in eine Lösung, die einen Farbstoff (40) enthält, wodurch der Farbstoff (40) in den porösen Film (30) absorbiert wird.

## Revendications

1. Cellule solaire comportant :
un substrat (10) ;
une électrode (11) formée sur le substrat (10) ; et
une couche d'absorption de lumière formée sur l'électrode (11) et comportant un film poreux (30) qui comprend des particules (31) d'oxyde métallique et ayant un diamètre moyen de particules du niveau nanométrique et un colorant (40) adsorbé sur la surface des particules (31) d'oxyde métallique,
**caractérisée en ce qu'**une région d'élargissement de contact (16) est formée entre l'électrode (11) et la couche d'absorption de lumière, où la rugosité quadratique moyenne de surface de l'électrode (11) dans la région d'élargissement de contact (16) est comprise dans la plage de 10 nanomètres à 3000 nanomètres.

2. Cellule solaire selon la revendication 1, dans laquelle la rugosité quadratique moyenne de la surface de l'électrode (11) est comprise dans la plage de 50 nanomètres à 1500 nanomètres.

3. Cellule solaire selon la revendication 2, dans laquelle la rugosité quadratique moyenne de la surface de l'électrode (11) est comprise dans la plage de 150 nanomètres à 400 nanomètres.

4. Cellule solaire selon l'une quelconque des revendications précédentes, dans laquelle une configuration de la région d'élargissement de contact (16) comprend les formes de marches, de mailles, de rayures, d'entailles ou de lits.

5. Cellule solaire selon l'une quelconque des revendications précédentes, dans laquelle la rugosité quadratique moyenne de surface du substrat (10) est comprise dans la plage de 10 nanomètres à 3000 nanomètres.

6. Cellulaire solaire selon la revendication 5, comportant en outre :
un second substrat (20), les premier et second substrats (10, 20) étant face à face ; et
une seconde électrode (21) formée sur le substrat (20) ;
dans laquelle la rugosité quadratique moyenne de surface de la première électrode (11) est supérieure à la rugosité quadratique moyenne de surface de la seconde électrode (21).

7. Cellule solaire selon l'une quelconque des revendications précédentes, laquelle cellule solaire est une cellule solaire sensibilisée par un colorant.

8. Procédé de fabrication d'une cellule solaire comprenant les étapes qui consistent :
à produire un substrat (10) ;
à former une électrode (11) sur une surface du substrat (10) et à commander des conditions de traitement de la formation de façon qu'une région d'élargissement de contact (16), qui est prévue pour porter une couche d'absorption de lumière, soit formée sur l'électrode (11), dans lequel les conditions de traitement sont choisies de façon que la rugosité moyenne quadratique d'une surface de la région d'élargissement de contact (16) de l'électrode (11) soit comprise dans la plage de 10 nanomètres à 3000 nanomètres ; et
à former la couche d'adsorption de lumière sur l'électrode (11), la couche d'absorption de lumière comportant un film poreux (30) qui comprend des particules (31) d'oxyde métallique ayant un diamètre moyen de particules du niveau nanométrique et un colorant (40) adsorbé sur la surface des particules (31) d'oxyde métallique.

9. Procédé selon la revendication 8, dans lequel les conditions de traitement dans l'étape de formation de l'électrode (11) sont choisies de façon que la rugosité moyenne quadratique d'une surface de la région d'élargissement de contact (16) de l'électrode (11) soit comprise dans la plage de 50 nanomètres à 1500 nanomètres.

10. Procédé selon la revendication 9, dans lequel les conditions de traitement dans l'étape de formation de l'électrode (11) sont choisies de façon que la rugosité moyenne quadratique d'une surface de la région d'élargissement de contact (16) de l'électrode (11) soit comprise dans la plage de 150 nanomètres à 400 nanomètres.

11. Procédé selon l'une des revendications 8 à 10, dans lequel l'étape de production d'un substrat (10) comprend la commande des conditions de traitement pour la formation du substrat (10) de manière que la rugosité quadratique moyenne d'une surface du substrat (10) soit comprise dans la plage de 10 nanomètres à 3000 nanomètres dans une région qui est prévue pour porter l'électrode (11).

12. Procédé selon la revendication 11, dans lequel la rugosité moyenne quadratique du substrat (10) est ajustée par un traitement mécanique ou chimique.

13. Procédé selon la revendication 12, dans lequel le traitement mécanique ou chimique comprend l'un quelconque d'un sablage, d'une formation de rayures ou d'une attaque par plasma.

14. Procédé selon la revendication 12, dans lequel le traitement chimique comprend une attaque effectuée avec une solution choisie dans le groupe constitué de l'acide nitrique, de l'acide chlorhydrique, de l'acide fluorhydrique et de mélanges de ceux-ci.

15. Procédé selon l'une des revendications 8 à 14, dans lequel la cellule solaire est une cellule solaire sensibilisée par un colorant et dans lequel l'étape de formation de la couche d'absorption de lumière sur l'électrode (11) comprend :
le revêtement d'une pâte contenant des particules (31) d'oxyde métallique ayant un diamètre moyen de particules de niveau nanométrique sur l'électrode (11) et le traitement thermique de cette pâte pour former un film poreux (30) ; et
l'immersion de l'électrode (11) avec le film poreux (30) dans une solution contenant un colorant (40) et l'absorption, ainsi, du colorant (40) dans le film poreux (30).
